# EUROPÄISCHE PATENTSCHRIFT

(11) **EP 0 610 183 B1**
(45) Veröffentlichungstag und Bekanntmachung des Hinweises auf die Patenterteilung: **10.05.1995**
(21) Anmeldenummer: 91918568.6
(22) Anmeldetag: 30.10.1991
(51) Int. Cl.: G03F 1/00, G03F 7/207, G02F 2/02, G02B 27/54

(54) **BELICHTUNGSVORRICHTUNG**
EXPOSURE DEVICE
DISPOSITIF D'EXPOSITION LUMINEUSE

(43) Veröffentlichungstag der Anmeldung: 17.08.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: VOGT, Holger, D-45481 Mülheim (DE); KÜCK, Heinz, D-47249 Duisburg (DE); HESS, Günther, D-47057 Duisburg (DE); GEHNER, Andreas, D-4100 Duisburg 1 (DE)
(74) Vertreter: Schoppe, Fritz, Dipl.-Ing.
(86) Internationale Anmeldenummer: DE9100859
(87) Internationale Veröffentlichungsnummer: WO9309469

(56) Entgegenhaltungen:
- US-A- 3 729 252
- US-A- 3 785 736
- US-A- 4 592 648
- US-A- 4 675 702
- US-A- 4 728 185
- Proceedings of SPIE, Band. 1018, 1988, W. Brinker et al.: "Deformation behavior of thin viscoelastic layers used in an activematrix-addressed spatial light modulator"
- Firmenschrift Texas Instrument, JMF 008:0260; 10/87, "The deformable mirror device"

## Beschreibung

Die vorliegende Erfindung betrifft eine Belichtungsvorrichtung zum Herstellen von Vorlagen, wie beispielsweise Retikels und Masken, für die Fertigung elektronischer Elemente oder zum Direktbelichten von Scheiben und Substraten bei den für die Herstellung notwendigen fotolithographischen Schritten oder von Strukturen mit lichtempfindlichen Schichten, wobei diese Belichtungsvorrichtung eine Lichtquelle und einen Mustergenerator umfaßt.

Insbesondere befaßt sich die vorliegende Erfindung mit der Herstellung von Vorlagen, Retikels und Masken oder mit der Direktbelichtung im Mikrometerbereich bei der Halbleiterfertigung, der Fertigung von integrierten Schaltkreisen, der Hybridfertigung und der Fertigung von flachen Bildschirmen sowie ähnlichen Fertigungsverfahren, bei denen Belichtungsprozesse eingesetzt werden. Insbesondere befaßt sich die Erfindung mit einer Belichtungsvorrichtung, wie sie für die Direktbelichtung von Halbleiterscheiben in der Halbleiterfertigung und von Substraten in der Hybrid- und Verbindungstechnik eingesetzt werden kann.

Bei der Herstellung von Retikels, die Belichtungsschablonen für die fotolithographische Schaltkreisherstellung sind, sowie bei der Herstellung von Masken und bei der Direktbelichtung von Halbleiterprodukten werden Elektronenstrahlschreiber, Laserstrahlgeräte und optische Mustergeneratoren mit einer Laserlichtquelle oder einer Quecksilberdampflampe eingesetzt. Optische Mustergeneratoren nach dem Stand der Technik erzeugen die gewünschten Strukturen durch das aufeinanderfolgende, einzelne Belichten von Rechteckfenstern, die durch mechanische Rechteckblenden festgelegt werden. Die Komplexität der zu erzeugenden Struktur bestimmt die Anzahl der erforderlichen Belichtungsrechtecke, die wiederum die Schreibzeit oder Belichtungszeit für die Struktur bestimmt. Die Genauigkeit der verwendeten mechanischen Rechteckblenden begrenzt wiederum die Genauigkeit der mit diesen bekannten Mustergeneratoren erzeugbaren Strukturen.

Bei Laserstrahlgeräten nach dem Stand der Technik wird die zu belichtende Fläche mit einem Laserstrahl abgerastert. Die Schreibgeschwindigkeit oder Belichtungsgeschwindigkeit derartiger Laserstrahlgeräte ist durch den für das Rasterverfahren notwendigen seriellen Datenfluß begrenzt. Ferner bedingen derartige Laserstrahlgeräte einen hohen mechanischoptischen Aufwand.

Die im Stand der Technik eingesetzten Elektronenstrahlgeräte können nur für die Belichtung von elektronenempfindlichen, speziellen Photolacksystemen verwendet werden und erfordern, verglichen mit den oben beschriebenen Laserstrahlgeräten, zusätzlich eine Hochvakuumtechnik. Elektronenstrahlgeräte erfordern daher sehr hohe Investitions- und Betriebskosten.

Aus der Fachveröffentlichung W. Brinker et al, "Deformation behavior of thin viscoelastic layers used in an active -matrix-addressed spatial light modulator", Proceedings of SPIE 1989, Band 1018, (1988), Seiten 79-85, ist es bereits bekannt, für die Erzeugung von Fernsehbildern oder für Zwecke der Bildanzeige ein reflektives optisches Schlieren-System mit einem aktiven, Matrix-adressierten, viskoelastischen Flächenlichtmodulator einzusetzen. Dieser umfaßt eine Dauerlichtquelle, deren Licht durch ein geeignetes optisches System vertikal auf die Oberfläche des Flächenlichtmodulators auffällt. Oberflächenbereiche des Flächenlichtmodulators sind bei Adressierung von Steuerelektroden deformierbar, so daß das auf die Oberfläche fallende Licht bei adressierten Oberflächenelementen gebeugt, bei nicht-adressierten Oberflächenelementen ungebeugt reflektiert wird. Das ungebeugte Licht wird zur Lichtquelle zurückgelenkt, während das gebeugte Licht über das optische Schlierensystem zur Bilderzeugung auf dem Fernsehbildschirm oder auf einer Bildanzeigefläche verwendet wird.

Aus der Firmenschrift Texas Instruments, JMF 008:0260; 10/87, "The deformable mirror device," ist ein Flächenlichtmodulator bekannt, dessen reflektierende Oberfläche aus einer Vielzahl von elektrisch adressierbaren, mechanisch verformbaren Zungen besteht.

Die ältere, nicht vorveröffentlichte internationale Patentanmeldung PCT/DE91/00375 (WO-A-91/17 483) beschreibt eine Belichtungsvorrichtung zum Herstellen von Vorlagen oder zum Direktbelichten von elektronischen Elementen und weist eine Lichtquelle sowie einen Mustergenerator auf. Der Mustergenerator hat ein optisches Schlierensystem und einen aktiven, Matrix-adressierbaren Flächenlichtmodulator, der eine viskoelastische Steuerschicht mit reflektierender Oberfläche hat. Zwischen dem Schlierenobjektiv und dem Projektionsobjektiv des Schlierensystems ist eine Spiegelvorrichtung angeordnet, die vorzugsweise eine Doppelfunktion hat und zur Umlenkung des Lichtes von der Lichtquelle auf den Flächenlichtmodulator und als Filtervorrichtung zum Herausfiltern von ungebeugt reflektiertem Licht dient. Das Schlierenobjektiv ist nahe an dem Flächenlichtmodulator angeordnet. Ein Positioniertisch, der verfahrbar ist, dient zur Aufnahme der Vorlage oder des elektronischen Elementes. Die Lichteinkopplung von der Lichtquelle über die Spiegelvorrichtung auf den Flächenlichtmodulator erfolgt bei dieser Belichtungsvorrichtung mit einer im Strahlengang vor der Spiegelvorrichtung angeordneten Fokussiereinrichtung, die das von der Lichtquelle kommende Licht auf die Spiegelvorrichtung fokussiert. Mit anderen Worten wird eine virtuelle Punktlichtquelle zur Beleuchtung des Flächenlichtmodulators bei dieser Belichtungsvorrichtung nötigerweise am Ort der Spiegelvorrichtung erzeugt, woraus sich Einschränkungen hinsichtlich der Gestaltung der Belichtungsvorrichtung und der Anordnung ihrer Spiegelvorrichtung sowie ihrer Filtervorrichtung ergeben.

Die US-A-4,675,702 zeigt eine Flächenbelichtungsvorrichtung, die beispielsweise zur Belichtung von photoempfindlichen Filmen einsetzbar ist und als sog. "Photoplotter" ausgeführt sein kann. Diese Belichtungsvorrichtung umfaßt eine Lichtquelle zum Erzeugen eines im wesentlichen parallelen Lichtbündels, welches durch ein ansteuerbares Lichtmatrixventil fällt, das z.B. durch eine Flüssigkristallschicht gebildet sein kann, wodurch nicht zu belichtende Bereiche des photoempfindlichen Filmes definiert werden.

Die US-A-4,728,185 befaßt sich mit einem Schlieren-Abbildungssystem, welches mit Lichtmodulatoren bei einem optischen Printer eingesetzt werden kann. Die Lichtventile selbst können als elektronisch adressierbare Flächenlichtventile ausgeführt sein. Die bekannte Belichtungsvorrichtung ist derart angeordnet, daß nur diejenigen Teile des balkenförmigen Lichtmodulators, die adressiert sind, auf einer photoempfindlichen Schicht abgebildet werden.

Die US-A-4,592,648 offenbart ein Belichtungssystem für die Abbildung einer Vorlage auf einer lichtempfindlichen Schicht auf einem Halbleitermaterial mit einem verfahrbaren Positioniertisch.

Ausgehend von diesem Stand der Technik liegt der vorliegenden Erfindung die Aufgabe zugrunde, eine Belichtungsvorrichtung zum Herstellen von Vorlagen oder zum Direktbelichten von elektronischen Elementen zu schaffen, die bei einfacher Struktur der Belichtungsvorrichtung eine gegenüber Laserstrahlanlagen oder Elektronenstrahlanlagen reduzierte Belichtungszeit oder Schreibzeit ermöglicht.

Diese Aufgabe wird durch eine Belichtungsvorrichtung gemäß Patentanspruch 1 gelöst.

Gemäß der Erfindung umfaßt die Belichtungsvorrichtung zum Herstellen von Vorlagen für die Fertigung elektronischer Elemente oder zum Direktbelichten von Scheiben oder Substraten bei den für ihre Herstellung notwendigen fotolithographischen Schritten oder von Strukturen mit lichtempfindlichen Schichten eine Lichtquelle und einen Mustergenerator, der seinerseits ein optisches Schlierensystem und einen aktiven, Matrix-adressierbaren Flächenlichtmodulator aufweist. Der Flächenlichtmodulator hat eine reflektierende Oberfläche, deren adressierte Oberflächenbereiche einfallendes Licht beugen und deren nicht-adressierte Oberflächenbereiche einfallendes Licht reflektieren. Das Schlierensystem hat ein Flächenlichtmodulator-seitiges Schlierenobjektiv, ein dem Flächenlichtmodulator abgewandtes Projektionsobjektiv und eine zwischen diesen Objektiven angeordnete Spiegelvorrichtung, die Licht von der Lichtquelle auf die Oberfläche des Flächenlichtmodulators richtet. Das Schlierenobjektiv ist mit einem bezogen auf seine Brennweite geringen Abstand zu dem Flächenlichtmodulator angeordnet. Die Belichtungsvorrichtung umfaßt eine Fokussierungsvorrichtung zum Fokussieren des Lichts von der Lichtquelle in zumindest einen, von der Spiegelvorrichtung beabstandeten Punkt, dem zumindest eine virtuelle Punktlichtquelle durch Spiegelung des Punktes an der Spiegelvorrichtung zugeordnet-werden kann. Eine Filtervorrichtung in der Beugungsbildebene der virtuellen Punktlichtquelle zwischen dem Schlierenobjektiv und dem Projektionsobjektiv ist derart ausgebildet, daß sie entweder in einem sogenannten negativen Mode das von den adressierten Oberflächenbereichen des Flächenlichtmodulators reflektierte, gebeugte Licht herausfiltert und das von den nicht-adressierten Oberflächenbereichen reflektierte, ungebeugte Licht über das Projektionsobjektiv zu der Vorlage oder dem elektronischen Element oder der Struktur hindurchläßt oder in einem sogenannten positiven Mode das von den nicht-adressierten Oberflächenbereichen des Flächenlichtmodulators reflektierte, ungebeugte Licht herausfiltert und das von den adressierten Oberflächenbereichen reflektierte, gebeugte Licht über das Projektionsobjektiv zu der Vorlage oder dem elektronischen Element oder der Struktur hindurchläßt. Ferner umfaßt die Belichtungsvorrichtung einen verfahrbaren Positioniertisch, auf dem die Vorlage oder das elektronische Element oder die Struktur derart festlegbar ist, daß die Oberflächenbereiche des Flächenlichtmodulators auf der Vorlage oder dem elektronischen Element oder der Struktur scharf abbildbar sind.

Gemäß einem wesentlichen Erfindungsaspekt handelt es sich bei der Lichtquelle der erfindungsgemäßen Belichtungsvorrichtung um eine gepulste Laserlichtquelle, deren Pulsdauer kürzer ist als der Quotient der minimalen Abmessung der zu erzeugenden Struktur geteilt durch die Verfahrgeschwindigkeit des Positioniertisches. Bei dieser Ausgestaltung ermöglicht die erfindungsgemäße Belichtungsvorrichtung ein stroboskopartiges Belichten der Vorlage bzw. des elektronischen Elementes bzw. der Struktur während eines im wesentlichen kontinuierlichen Verfahrens des Positioniertisches, wodurch sehr hohe Schreibgeschwindigkeiten oder Belichtungsgeschwindigkeiten erzielt werden.

Trotz der hohen Belichtungsintensität der einzelnen Laserlichtpulse macht die Erfindung von einem Flächenlichtmodulator Gebrauch, wie er im Stand der Technik nur für Anwendungsfälle von sehr niedriger Belichtungsintensität herangezogen wird, wie dies beispielsweise bei Fernsehbildschirmen der Fall ist. Da jedoch die Laserlichtpulse bei der erfindungsgemäßen Belichtungsvorrichtung von nur niedriger Dauer sind, bleibt der Flächenlichtmodulator den thermischen Anforderungen gewachsen. Durch die schnelle Programmierbarkeit oder Adressierbarkeit des Flächenlichtmodulators kann dieser während der Verfahrbewegung des Positioniertisches zwischen zwei aufeinanderfolgenden Teilbildern einer zu erzeugenden Gesamtstruktur umprogrammiert oder umadressiert werden. Damit ist nicht nur im Falle der Direktbelichtung von Halbleiterscheiben mit wiederholten Strukturen eine kurze Belichtungspulsfolge möglich, sondern ebenfalls aufgrund der schnellen Umprogrammierbarkeit des Flächenlichtmodulators die Erzeugung von unregelmäßigen Strukturen möglich.

Weiterbildungen der erfindungsgemäßen Belichtungsvorrichtung sind in den Unteransprüchen angegeben.

Nachfolgend wird unter Bezugnahme auf die beiliegenden Zeichnungen eine bevorzugte Ausführungsform der erfindungsgemäßen Belichtungsvorrichtung näher erläutert. Es zeigen:
- Fig. 1: eine schematische Darstellung der Gesamtstruktur der erfindungsgemäßen Belichtungsvorrichtung;
- Fig. 2: eine Detaildarstellung einer ersten Ausführungsform der erfindungsgemäßen Belichtungsvorrichtung;
- Fig. 3: eine Detaildarstellung einer zweiten Ausführungsform der erfindungsgemäßen Belichtungsvorrichtung; und
- Fig. 4: eine Detaildarstellung einer dritten Ausführungsform der erfindungsgemäßen Belichtungsvorrichtung.

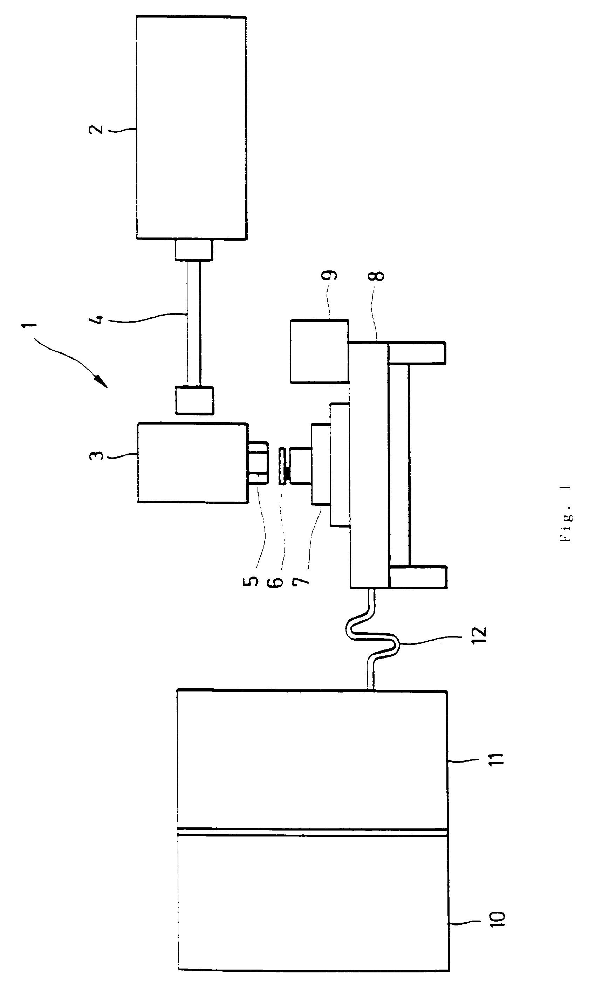

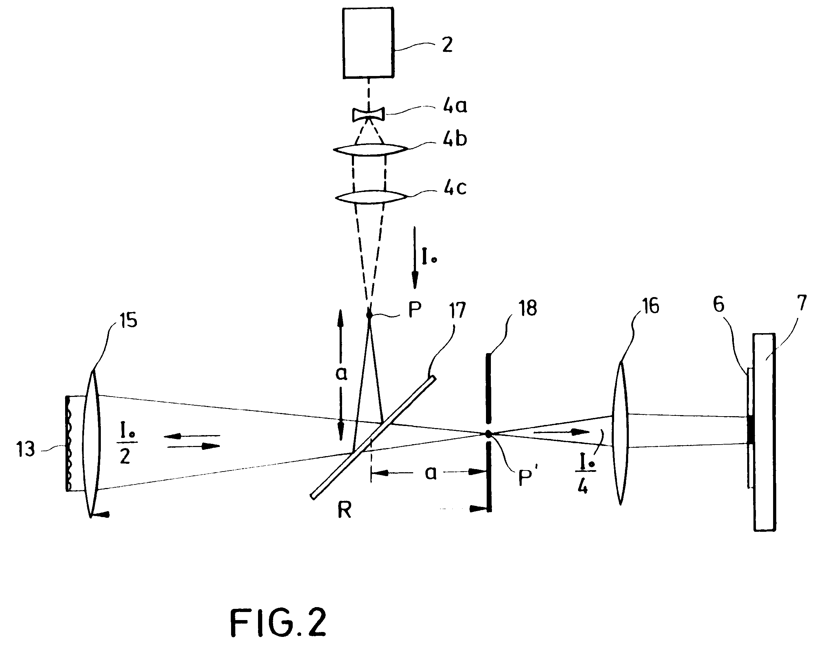

Die in Fig. 1 gezeigte Belichtungsvorrichtung ist in ihrer Gesamtheit mit den Bezugszeichen "1" bezeichnet und dient zum Herstellen von Vorlagen, wie beispielsweise Retikels und Masken für die Fertigung elektronischer Elemente, oder zum Direktbelichten von Substraten oder von Strukturen mit lichtempfindlichen Schichten. Die erfindungsgemäße Belichtungsvorrichtung 1 weist eine Excimer-Laserlichtquelle 2 auf. Diese Excimer-Laserlichtquelle ist eine Gasentladungslaservorrichtung mit Wellenlängen im UV-Bereich von etwa 450 bis 150 nm, die in steuerbarer Weise Lichtpulse mit sehr hoher Lichtintensität pro Puls und hoher Wiederholrate abgibt. Die Excimer-Laserlichtquelle 2 steht mit einem Mustergenerator 3 über eine beleuchtende optische Einheit 4 in Verbindung. Die beleuchtende optische Einheit 4 dient dazu, das Licht von der Excimer-Laserlichtquelle 2 einem später zu erläuternden Flächenlichtmodulator 13 des Mustergenerators 3 in der Weise zuzuführen, daß die Lichtapertur der Excimer-Laserlichtquelle 2 an die Oberfläche des Flächenlichtmodulators angepaßt wird. Bei bevorzugten Ausführungsformen, die nachfolgend unter Bezugnahme auf die Fig. 2 bis 4 erläutert werden, ist die beleuchtende optische Einheit 4 durch Linsensysteme von an sich bekannter Struktur gebildet.

Der Mustergenerator bildet mittels einer projizierenden optischen Einheit 5 in noch näher zu beschreibenden Weise ein Muster auf eine Vorlage 6 ab, die von einem x-y-Θ-Positioniertisch gehalten wird.

Die projizierende optische Einheit 5 dient nicht nur zur Abbildung des von dem Mustergenerator 3 erzeugten Musters auf der Vorlage 6, sondern gleichfalls zur gewünschten Vergrösserung oder Verkleinerung bei der Abbildung und, soweit dies gewünscht ist, zur Autofokussierung der Abbildung auf der Vorlage 6.

Wie bereits erläutert, kann es sich bei der Vorlage beispielsweise um Retikels oder Masken handeln. Im Falle der Direktbelichtung, die gleichfalls eingangs erläutert wurde, trägt der x-y-Θ-Positioniertisch 7 anstelle der Vorlage 6 eine zu belichtende Halbleiterscheibe, ein sonstiges, mittels Photolithographie zu erzeugendes Element oder eine Struktur mit einer lichtempfindlichen Schicht, die zu beschriften oder zu belichten ist.

Der Positioniertisch 7 ist auf einer schwingungsisolierenden Trägerkonstruktion 8 angeordnet. Auf dieser Trägerkonstruktion 8 kann eine Be- und Entladestation 9 für weitere Vorlagen 6 bzw. Halbleiterelemente oder zu belichtende Strukturen vorgesehen sein. Die Be- und Entladestation 9 kann in einer in der Halbleiterfertigung üblichen Art zum automatischen Beschicken des Positioniertisches 7 mit den zu belichtenden Vorlagen oder Substraten oder sonstigen Halbleiterelementen ausgestaltet sein.

Ein Steuerrechner 10 mit zugehöriger Steuerelektronik 11 übernimmt alle Steuerfunktionen für die Belichtungsvorrichtung. Insbesondere stehen der Steuerrechner 10 und die Steuerelektronik 11 mit dem Positioniertisch 7 zum Zwecke der rechnergesteuerten Lagesteuerung des Positioniertisches in Verbindung. Der Steuerrechner 10 programmiert bzw. adressiert den Mustergenerator 3 in Abhängigkeit von der jeweiligen Steuerlage des Positioniertisches 7 zum aufeinanderfolgenden Erzeugen von Teilbildern auf der Vorlage 6, aus denen sich die belichtete Gesamtstruktur ergibt. Als Datenträger wird eine Magnetbandeinheit oder eine LAN-Schnittstelle (nicht dargestellt) eingesetzt.

Wie in Fig. 2 dargestellt ist, umfaßt der Mustergenerator 3 einen Flächenlichtmodulator 13, der auch als zweidimensionaler Lichtmodulator bezeichnet werden kann, sowie ein optisches Schlierensystem, das ein dem Flächenlichtmodulator 13 zugewandtes Schlierenobjektiv 15, ein dem Flächenlichtmodulator 13 abgewandtes Projektionsobjektiv 16 und eine zwischen dem Schlierenobjektiv 15 und dem Projektionsobjektiv 16 angeordnete Spiegelvorrichtung 17 aufweist. Bei dem gezeigten, bevorzugten Ausführungsbeispiel ist die Spiegelvorrichtung als teildurchlässiger Spiegel 17 dargestellt, der in einem 45°-Winkel zu der optischen Achse der Objektive 15, 16 in der Weise angeordnet ist, daß der Schnittpunkt der optischen Achse der Objektive 15, 16 mit dem teildurchlässigen Spiegel 17 um einen Abstand a von der Brennebene des Schlierenobjektivs 15 auf dieses hin versetzt angeordnet ist.

Das Schlierenobjektiv 15 ist seinerseits mit einem bezogen auf seine Brennweite geringen Abstand zu dem Flächenlichtmodulator 13 angeordnet.

Die beleuchtende optische Einheit, die im Strahlengang vor der Spiegelvorrichtung 17 liegt, umfaßt neben der bereits erwähnten Excimer-Laserlichtquelle 2 eine Strahlaufweitungsoptik 4a, 4b und eine Fokussierungsoptik 4c, die bei dem gezeigten, bevorzugten Ausführungsbeispiel das Licht in einem einzigen Punkt P fokussiert, wobei bei der hier gezeigten Anordnung mit symmetrischer Lichteinkopplung bezogen auf die optische Achse der Abstand dieses Punktes P von dem Schnittpunkt der optischen Achse mit der Spiegelvorrichtung 17 dem Abstand a gleicht, den der genannte Schnittpunkt der optischen Achse mit der Spiegelvorrichtung 17 von der Brennebene des Schlierenobjektivs 15 hat.

Mit anderen Worten sind bei dem hier gezeigten Ausführungsbeispiel die Spiegelvorrichtung 17 und die Fokussiervorrichtung 4c derart angeordnet, daß dem Fokuspunkt P der Fokussiereinrichtung eine virtuelle Punktlichtquelle P′ durch Spiegelung des Punktes P an der Spiegelvorrichtung 17 zugeordnet ist, wobei diese virtuelle Punktlichtquelle P′ bei diesem Ausführungsbeispiel in der Brennebene des Schlierenobjektivs 15 liegt. Demzufolge liegt auch das Beugungsbild der virtuellen Punktlichtquelle P′ in der Brennebene des Schlierenobjektivs 15, so daß eine Filtervorrichtung 18 zum Herausfiltern unerwünschter Beugungsordnungen, welche in der Beugungsbildebene liegt, bei diesem Ausführungsbeispiel in der Brennebene des Schlierenobjektivs 15 angeordnet ist.

Bei der Ausführungsform gemäß Fig. 2 ist der Fokuspunkt P der Fokussiervorrichtung 4c derart bezogen auf die Spiegelvorrichtung 17 angeordnet, daß die dem Fokuspunkt durch Spiegelung zugeordnete virtuelle Punktlichtquelle P′ in der Brennebene des Schlierenobjektivs liegt. In Abweichung von dieser Ausgestaltung kann der Fokuspunkt der Fokussiervorrichtung 4c auch derart verschoben werden, daß die diesem zugeordnete virtuelle Punktlichtquelle P′ gegenüber der Brennebene des Schlierenobjektivs 15 weiter auf dieses zu verschoben wird. Hierdurch verschiebt sich die Beugungsbildebene der virtuellen Punktlichtquelle P′ aus der Brennebene des Schlierenobjektivs 15 heraus in Richtung auf das Projektionsobjektiv 16 hin. Da die Filtervorrichtung 18 in der Beugungsbildebene anzuordnen ist, muß sie gegenüber der in Fig. 2 gezeigten Ausgestaltung bei der soeben geschilderten Ausführungsform ebenfalls weiter auf das Projektionsobjektiv 16 hin verschoben werden, so daß die Filtervorrichtung 18 in der Beugungsbildebene zu liegen kommt.

Der Flächenlichtmodulator 13 umfaßt eine viskoelastische Steuerschicht 18, die in Richtung zu dem Schlierenobjektiv 15 von einer reflektierenden Oberfläche 19 abgeschlossen ist, welche beispielsweise von einem Metallfilm gebildet sein kann. Ferner umfaßt der Flächenlichtmodulator 13 eine sogenannte aktive Adressierungsmatrix 20, die aus einer monolithisch integrierten Anordnung von MOS-Transistoren mit zugeordneten Steuerelektrodenpaaren gebildet sein kann.

Typischerweise umfaßt die Adressierungsmatrix 20 2000 x 2000 Bildelemente. Jedem Bildelement oder Oberflächenbereich 19a, 19b, ... der reflektierenden Oberfläche 19 der Adressierungsmatrix 20 sind zwei Transistoren mit ein oder mehreren Elektrodenpaaren zugeordnet, die jeweils ein Diffraktionsgitter mit einer oder mehreren Gitterperioden mit der viskoelastischen Schicht 18 und ihrer reflektierenden Oberfläche 19 bilden.

Wenn ein Oberflächenbereich 19a, 19b, ... durch Anlegen von entgegengesetzten Spannungen an den beiden Elektroden eines Elektrodenpaares des betreffenden Oberflächenbereiches adressiert wird (logisch "1"), nimmt die reflektierende Oberfläche 19 einen im Querschnitt etwa sinusförmigen Verlauf an. Bei Nicht-Adressierung ist der betreffende Oberflächenbereich 19a, 19b, ... eben.

Die Filtervorrichtung 18 kann für einen sogenannten positiven Mode so ausgestaltet sein, daß sie das von dem Flächenlichtmodulator 13 kommende Licht der nullten Beugungsordnung herausfiltert und das Licht von zumindest einer der höheren Beugungsordnungen durchläßt, wodurch diejenigen Bereiche der Projektion des Flächenlichtmodulators 13 auf die zu belichtende, lichtempfindliche Schicht 6, welche den adressierten Modulatorbereichen entsprechen, durch Belichtung abgebildet werden.

In Abweichung hiervon kann die Filtervorrichtung 18 auch, wie dies in Fig. 2 dargestellt ist, zur Realisierung des sogenannten negativen Mode so ausgestaltet sein, daß sie lediglich Licht der nullten Beugungsordnung vom Flächenlichtmodulator 13 durchläßt. Somit wird lediglich das von den nicht-adressierten Oberflächenbereichen 19a, 19b, ... des Flächenlichtmodulators 13 reflektierte, ungebeugte Licht über das Projektionsobjektiv 16 zu der Vorlage 6 oder dem elektronischen Element oder der Struktur durchgelassen, so daß das Projektionsbild im negativen Mode den nicht-adressierten Bereichen entspricht.

Bei dem soeben unter Bezugnahme auf Fig. 2 beschriebenen System erfolgt die Lichteinkopplung von der Laserlichtquelle 2 über die Optik 4 und die Spiegelvorrichtung 17 in das System symmetrisch zur optischen Achse der Objektive 15, 16, so daß das von der virtuellen Punktlichtquelle P′ auf den Flächenlichtmodulator 13 auftreffende Licht auf diesen im wesentlichen senkrecht einfällt.

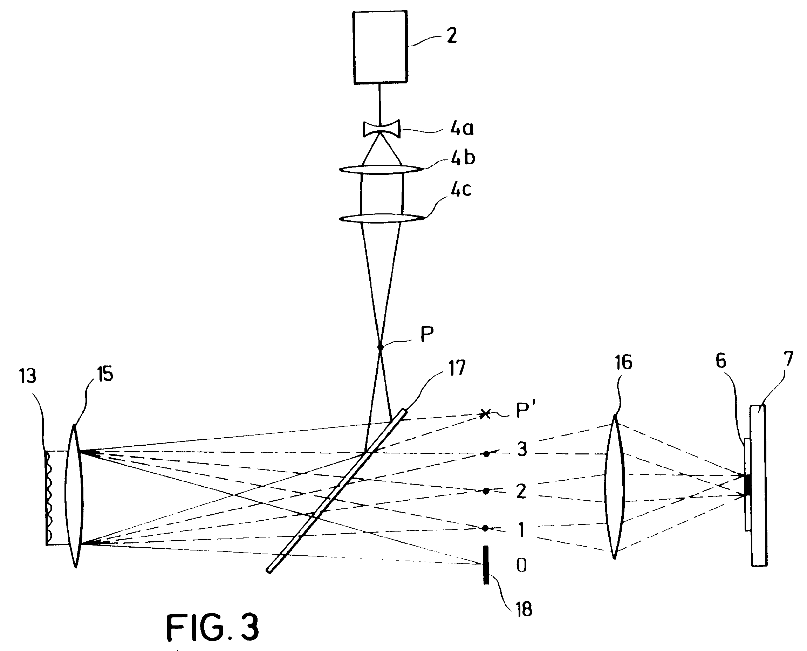

Wie nachfolgend unter Bezugnahme auf Fig. 3 erläutert werden wird, ist jedoch ein schräger Lichteinfall bei nicht-symmetrischer Einkopplung möglich.

Bei der Ausgestaltung gemäß Fig. 3, die mit Ausnahme der nachfolgend beschriebenen Abweichungen mit der Ausführungsform von Fig. 2 übereinstimmt, ist der teildurchlässige Spiegel 17, der hier die Spiegelvorrichtung bildet, in einem vom 45°-Winkel abweichenden Winkel angeordnet. Der Abstand des Fokuspunktes P der Fokussiervorrichtung 4c von dem teildurchlässigen Spiegel 17 ist wiederum derart gewählt, daß die zu dem Punkt P zugeordnete virtuelle Punktlichtquelle P′ in der Brennebene des Schlierenobjektives 15 liegt. Hier ist jedoch aufgrund der Neigung des teildurchlässigen Spiegels 17 erreicht, daß die virtuelle Punktlichtquelle P′ außerhalb der optischen Achse der Objektive 15, 16 zu liegen kommt. Hierdurch wird der Flächenlichtmodulator 13 von der virtuellen Punktlichtquelle P′ mit einem schrägen Lichteinfall beaufschlagt.

Symmetrisch zu der virtuellen Punktlichtquelle P′ bezogen auf die optische Achse liegt eine als Blende ausgeführte Filtervorrichtung 18 zum Herausfiltern des Lichtes der nullten Beugungsordnung.

Die erste, zweite und dritte Beugungsordnung eines Seitenspektrums werden von dem Projektionsobjektiv 16 erfaßt und auf die Vorlage 6 abgebildet, die ihrerseits auf dem Projektionstisch 7 angeordnet ist.

Wenn, wie dies bei der in Fig. 3 gezeigten Anordnung der Fall ist, mit dem sogenannten positiven Mode gearbeitet wird, entsteht eine Projektion mit einer Feinstruktur. Verwendet man einen symmetrischen Aufbau, wie dieser beispielsweise in Fig. 2 gezeigt ist, so können aufgrund der numerischen Apertur des Projektionsobjektives 16 nur wenige Beugungsordnungen zur Abbildung gelangen, was zu einer relativ stark ausgeprägten Feinstruktur der Projektion führt. Um eine möglichst homogene Ausleuchtung mit geringer Feinstruktur zu erhalten, müssen möglichst viele der höheren Beugungsordnungen mit zur Abbildung gelangen. Bei der in Fig. 3 gezeigten asymmetrischen Anordnung können bei gleichbleibender Eintrittspupille des Projektionsobjektives 16 höhere Beugungsordnungen von einer der beiden Seiten des Spektrums abgebildet werden, wodurch die Homogenität der Abbildung verbessert wird.

In Abweichung zur Verwendung eines teildurchlässigen Spiegels, wie dieser bei der Ausführungsform gemäß Fig. 3 gezeigt ist, kann hier auch ein Spiegel vorgesehen sein, der dann lediglich in dem in Fig. 3 gezeigten Auftreffbereich des Lichtes von der Fokussiervorrichtung 4c auf die Spiegelvorrichtung vorzusehen ist, während der übrige Bereich für den Durchtritt der ersten bis dritten Beugungsordnung freizulassen ist.

Bei den Ausführungsformen nach den Fig. 2 und 3 wird das von der Laserlichtquelle 2 kommende Licht in lediglich einem einzigen Punkt P fokussiert, dem eine einzige virtuelle Punktlichtquelle P′ entspricht.

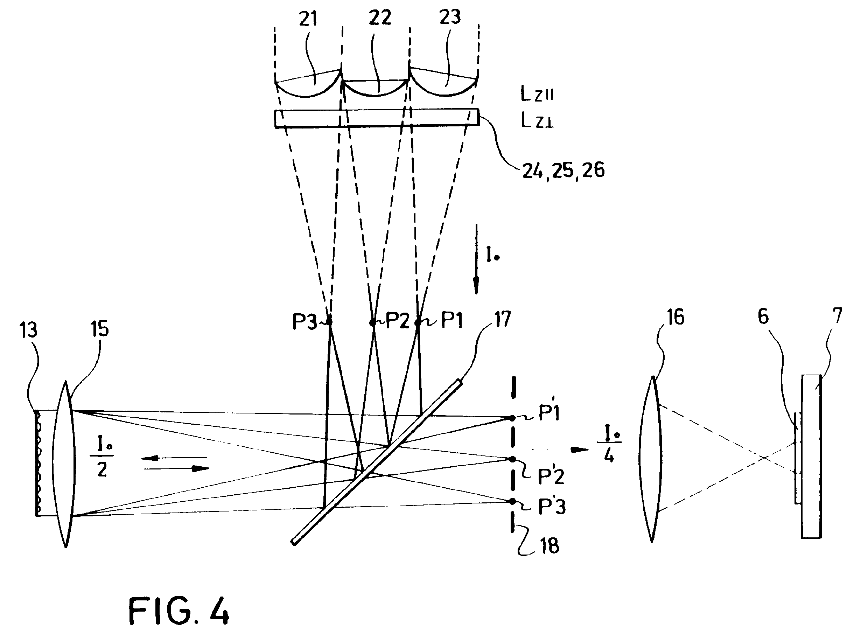

In Abweichung hiervon wird bei der dritten Ausführungsform gemäß Fig. 4 eine Mehrzahl von im wesentlichen punktsymmetrischen Punktlichtquellen (9 Punktlichtquellen) erzeugt, die jeweils die gesamte Fläche des Flächenlichtmodulators 13 beleuchten.

Zu diesem Zweck umfaßt die beleuchtende optische Einheit 4 neben der Strahlaufweitungsoptik 4a, 4b zwei zueinander vertikale Zylinderlinsensystemgruppen 21 bis 23, 24 bis 26.

Die im Strahlengang vorne liegenden Zylinderlinsen 21, 22, 23 sind parallel zur Phasenstruktur und somit in y-Richtung ausgerichtet, während die darauffolgenden Zylinderlinsen 24, 25, 26 senkrecht zur Phasenstruktur angeordnet sind. Diese hintereinander geschalteten Zylinderlinsensysteme fokussieren das Licht in neun Punkten, von denen drei P1, P2, P3 in der Zeichnung zu sehen sind. Die Lage der Fokuspunkte P1, P2, P3 bezogen auf die durch den teildurchlässigen Spiegel gebildete Spiegelvorrichtung 17 ist derart, daß den Fokuspunkten bei Spiegelung an der Spiegelvorrichtung 17 Punktlichtquellen P1′, P2′, P3′ zugeordnet sind, welche in der Brennebene des Schlierenobjektivs 15 liegen.

Bei sämtlichen Ausführungsformen wird während des Betriebes der Positioniertisch 7 kontinuierlich in einer vorbestimmten Bewegungsrichtung bewegt, während einander sich überlappende Teilbilder der gesamten abzubildenden Struktur auf die Vorlage 6 durch Pulsen der Excimer-Laserlichtquelle 2 abgebildet werden.

In der Regel umfaßt die Adressierungsmatrix 20 des Flächenlichtmodulators 13 eine Mehrzahl von funktionsunfähigen Bildelementen aufgrund von Herstellungsfehlern.

Im Falle einer Anlage, die im positiven Mode arbeitet, werden die defekten Bildelemente mit einer logischen "Null" angesteuert.

Im Falle einer im negativen Mode arbeitenden Anlage werden die defekten Bildelemente so behandelt, daß sie nicht länger reflektieren. Dies kann beispielsweise durch Abdecken mittels Farbe oder Zerstörung der reflektierenden Oberfläche geschehen.

Dadurch, daß jede Struktur auf der Vorlage 6 durch einander überlappende Teilbilder erzeugt wird, ist sichergestellt, daß jeder Teil der zu belichtenden Struktur wenigstens einmal durch ein funktionsfähiges Bildelement oder durch einen funktionsfähigen Oberflächenbereich belichtet wird.

Das Erzeugen der gesamten belichteten Struktur während des kontinuierlichen Verfahrens des Positioniertisches 7 führt nicht zu Unschärfen, da die Pulsdauer der gepulsten Excimer-Laserlichtquelle 2 kürzer ist als die minimale Abmessung der zu erzeugenden Struktur geteilt durch die Verfahrgeschwindigkeit des Positioniertisches 7.

Die Datenstruktur für die Ansteuerung der Adressierungsmatrix 20 entspricht im wesentlichen der Datenstruktur für die Ansteuerung von rasterorientierten Laserstrahl- oder Elektronenstrahlgeräten nach dem Stand der Technik. Ein erheblicher Vorteil bei der Verwendung der erfindungsgemäßen Belichtungsvorrichtung besteht darin, daß die für die Übertragung großer Datenmengen notwendige Zeit durch die Unterteilung der Adressierungsmatrix 20 und durch paralleles Programmieren von Teilmatritzen von beispielsweise 16 oder 32 Streifen fast beliebig reduziert werden kann. Ein weiterer Vorteil der erfindungsgemäßen Belichtungsvorrichtung 1 mit der Adressierungsmatrix 20 liegt darin, daß zum Zwecke der Belichtung von sich wiederholenden Strukturen, wie beispielsweise von regelmäßigen Anordnungen integrierter Schaltkreise auf einer Siliziumscheibe, die Adressierungsmatrix 20 für alle identischen Strukturen nur einmal programmiert und das programmierte Bild nur einmal gespeichert werden muß.

Es ist möglich, die erfindungsgemäße Belichtungsvorrichtung 1 mit einem Autokalibrationssystem und mit einem System für die Feinjustierung der Vorlagen 6 beim Direktschreiben zu versehen. Zu diesem Zweck werden Referenzmarken auf dem Positioniertisch 7 und auf der Vorlage 6 vorgesehen und die Adressierungsmatrix 20 als programmierbare Referenzmarke benutzt. Durch eine Autokalibration können Vergrößerungsfehler der projizierenden optischen Einheit 5 und sämtliche Positionierungsfehler kompensiert werden.

## Patentansprüche

1. Belichtungsvorrichtung zum Herstellen von Vorlagen für die Fertigung elektronischer Elemente oder zum Direktbelichten von Scheiben oder Substraten bei den für ihre Herstellung notwendigen fotolithographischen Schritten oder von Strukturen mit lichtempfindlichen Schichten, mit einer Lichtquelle (2) und einem Mustergenerator (3), bei der
- der Mustergenerator (3) ein optisches Schlierensystem (14) und einen aktiven, Matrix-adressierbaren Flächenlichtmodulator (13) aufweist,
- der Flächenlichtmodulator (13) eine reflektierende Oberfläche aufweist, deren adressierte Oberflächenbereiche einfallendes Licht gebeugt und deren nicht-adressierte Oberflächenbereiche einfallendes Licht ungebeugt reflektieren,
- das Schlierensystem (14) ein flächenlichtmodulatorseitiges Schlierenobjektiv (15), ein dem Flächenlichtmodulator (13) abgewandtes Projektionsobjektiv (16) und eine zwischen diesen Objektiven (15, 16) angeordnete Spiegelvorrichtung (17) aufweist, die Licht von der Lichtquelle (2) auf die Oberfläche des Flächenlichtmodulators (13) richtet,
- das Schlierenobjektiv (15) mit einem bezogen auf seine Brennweite geringen Abstand zu dem Flächenlichtmodulator (13) angeordnet ist,
- eine Fokussiereinrichtung (4c) zum Fokussieren des Lichts von der Lichtquelle (2) in zumindest einen, von der Spiegelvorrichtung (17) beabstandeten Punkt P vorgesehen ist, dem zumindest eine virtuelle Punktlichtquelle (P′) durch Spiegelung des Punktes P an der Spiegelvorrichtung (17) zugeordnet werden kann,
- eine Filtervorrichtung (18) in der Beugungsbildebene der virtuellen Punktlichtquelle (P′) zwischen dem Schlierenobjektiv (15) und dem Projektionsobjektiv (16) angeordnet ist, die derart ausgebildet ist, daß sie
-- entweder das von den adressierten Oberflächenbereichen des Flächenlichtmodulators (13) reflektierte, gebeugte Licht herausfiltert und das von den nicht-adressierten Oberflächenbereichen reflektierte, ungebeugte Licht über das Projektionsobjektiv (16) zu der Vorlage (6), der Scheibe, dem Substrat oder der Struktur durchläßt,
-- oder das von den nicht-adressierten Oberflächenbereichen des Flächenlichtmodulators (13) reflektierte, ungebeugte Licht herausfiltert und das von den adressierten Oberflächenbereichen reflektierte, gebeugte Licht über das Projektionsobjektiv (16) zu der Vorlage (6), der Scheibe, dem Substrat oder der Struktur durchläßt, und
- ein verfahrbarer Positioniertisch (7) vorgesehen ist, auf dem die Vorlage (6), die Scheibe, das Substrat oder die Struktur derart festlegbar ist, daß die Oberflächenbereiche des Flächenlichtmodulators (13) auf der Vorlage (6), der Scheibe, dem Substrat oder der Struktur scharf abbildbar sind,
- die Lichtquelle eine gepulste Laserlichtquelle (2) ist, die derart ausgebildet ist, daß deren Pulsdauer kürzer ist als die minimale Strukturabmessung der zu erzeugenden Vorlage, der Scheibe, des Substrates oder der Struktur geteilt durch die Verfahrgeschwindigkeit des Positioniertisches (7), und
- die Vorlage (6), die Scheibe, das Substrat oder die Struktur während des Verfahrens des Positioniertisches aus einer Mehrzahl von Teilbildern durch entsprechende Adressierung des Flächenlichtmodulators (13) zusammengesetzt wird.

2. Belichtungsvorrichtung nach Anspruch 1, bei der
- die Spiegelvorrichtung durch einen in einem 45°-Winkel zu der durch die Objektive (15, 16) festgelegten optischen Achse angeordneten teildurchlässigen Spiegel (17) gebildet ist.

3. Belichtungsvorrichtung nach Anspruch 1 oder 2, bei der
- die Filtervorrichtung (18) in der Brennebene des Schlierenobjektivs (15) angeordnet ist, und
- die Fokussiervorrichtung (4c) den Punkt P, in den das Licht von der Lichtquelle (2) fokussiert wird, mit einem solchen Abstand zu der Spiegelvorrichtung (17) erzeugt, daß die virtuelle Punktlichtquelle (P′), die dem Punkt P durch Spiegelung an der Spiegelvorrichtung (17) zugeordnet werden kann, in der Brennebene des Schlierenobjektivs (15) liegt.

4. Belichtungsvorrichtung nach Anspruch 1 oder 2, bei der
- die Fokussiervorrichtung (4c) den Punkt P, in den das Licht von der Lichtquelle (2) fokussiert wird, mit einem solchen Abstand zu der Spiegelvorrichtung (17) erzeugt, daß die virtuelle Punktlichtquelle (P′), die dem Punkt P durch Spiegelung der Spiegelvorrichtung (17) zugeordnet werden kann, mit einem ersten Versatz zu der Brennebene des Schlierenobjektivs (15) in Richtung zu dem Schlierenobjektiv (15) erzeugt wird, und
- die Filtervorrichtung (18) mit einem von dem ersten Versatz abhängigen zweiten Versatz zu der Brennebene des Schlierenobjektivs (15) in Richtung zu dem Projektionsobjektiv (16) angeordnet ist.

5. Belichtungsvorrichtung nach einem der Ansprüche 1 bis 4, bei der
- die Fokussiervorrichtung (4c) und/oder die Spiegelvorrichtung (17) derart angeordnet sind, daß das Licht derart schräg auf die Oberfläche des Flächenlichtmodulators (13) auftrifft, daß ungebeugtes Licht in einem Winkel zu der optischen Achse der Objektive (15, 16) reflektiert wird, und
- die Filtervorrichtung (18) ein Seitenspektrum des Lichts der ersten Beugungsordnung und/oder höherer Beugungsordnungen zu dem Projektionsobjektiv (16) durchläßt, jedoch Licht der nullten Beugungsordnung herausfiltert.

6. Belichtungsvorrichtung nach einem der Ansprüche 1 bis 5, bei der
- die gepulste Laserlichtquelle eine Excimer-Laserlichtquelle (2) ist.

7. Belichtungsvorrichtung nach einem der Ansprüche 1 bis 6, bei der
- jedem Oberflächenbereich des Flächenlichtmodulators (13) zwei Transistoren mit jeweils einem Steuerelektrodenpaar oder mehreren Steuerelektrodenpaaren zugeordnet sind, die bei Adressierung des betreffenden Oberflächenbereichs je ein oder mehrere Diffraktionsgitter mit der reflektierenden Oberfläche und der von ihr überdeckten viskoelastischen Steuerschicht erzeugen.

8. Belichtungsvorrichtung nach einem der Ansprüche 1 bis 7, bei der
- eine automatische Belade- und Entladevorrichtung für Scheiben oder Substrate, die eine vollautomatische Belichtung eines Loses von Scheiben oder Substraten gestattet, vorgesehen ist.

9. Belichtungsvorrichtung nach einem der Ansprüche 1 bis 8, bei der
- eine Vorjustiereinrichtung und eine Feinjustiereinrichtung vorgesehen sind, die das paßgenaue, wiederholte Belichten der Substrate während des Fertigungsprozesses gestatten.

10. Belichtungsvorrichtung nach Anspruch 9, bei der
- der Flächenlichtmodulator (13) als programmierbare Referenzmarke bei der Vor- und Feinjustierung benutzt wird.

11. Belichtungsvorrichtung nach einem der Ansprüche 1 bis 10, bei der
- die reflektierende Oberfläche des Flächenlichtmodulators (13) mit einer Flüssigkristallschicht bedeckt ist, und
- die elektrisch adressierbaren Oberflächenbereiche eine Phasenverschiebung und damit eine Beugung des einfallenden Lichtes bewirken.

12. Belichtungsvorrichtung nach einem der Ansprüche 1 bis 11, bei der
- der Flächenlichtmodulator (13) eine aus adressierbaren mechanischen Elementen bestehende, reflektierende Oberfläche aufweist, deren Verbiegung eine Phasenverschiebung und damit eine Beugung des Lichtes bewirken.

13. Belichtungsvorrichtung nach Anspruch 12, bei der
- die mechanischen Elemente als verbiegbare Zungen mit reflektierender Oberfläche ausgebildet sind.

## Claims

1. Illumination device for producing models used for manufacturing electronic elements, or for direct illumination of wafers or substrates during the photolithographic steps required for their production, or for direct illumination of structures including light-sensitive layers, comprising a light source (2) and a pattern generator (3), wherein
- the pattern generator (3) includes an optical schlieren system (14) and an active, matrix-addressable surface light modulator (13),
- the surface light modulator (13) has a reflective surface (19) whose addressed surface areas (19a, 19b, ...) reflect incident light as diffracted light and whose non-addressed surface areas (19a, 19b, ...) reflect incident light as undiffracted light,
- the schlieren system (14) comprises a schlieren lens (15) arranged on the side of the surface light modulator (13), a projection lens (16) facing away from the surface light modulator (13), and a mirror device (17) which is arranged between these lenses (15, 16) and which directs light coming from the light source (2) onto the surface (19) of the surface light modulator (13),
- the schlieren lens (15) is arranged at a distance from the surface light modulator (13) which is short relative to the focal length of said lens,
- a focussing means (4c) is provided for focussing the light coming from the light source (2) in at least one point P which is spaced apart from the mirror device (17) and which is adapted to have associated therewith at least one virtual point light source (P′) by reflecting the point P at the mirror device (17),
- a filter device (18) is arranged in the diffraction image plane of the virtual point light source (P′) between the schlieren lens (15) and the projection lens (16), said filter device (18) having a structural design of such a nature
-- that it will either filter out the diffracted light reflected by the addressed surface areas of the surface light modulator (13) and permit the undiffracted light, which is reflected by the non-addressed surface areas, to pass via the projection lens (16) to the model (6), the wafer, the substrate, or the structure,
-- or that it will filter out the undiffracted light, which is reflected by the non-addressed surface areas of the surface light modulator (13), and permit the diffracted light reflected by the addressed surface areas to pass via the projection lens (16) to the model (6), the wafer, the substrate, or the structure, and
- a displaceable positioning table (7) is provided on which the model (6), the wafer, the substrate or the structure can be secured in position in such a way that a sharp image of the surface areas of the surface light modulator (13) can be formed on the model (6), the wafer, the substrat, or on the structure.
- the light source is a pulsed laser light source (2) which is constructed such that its pulse duration is shorter than the minimum structural dimension of the model, wafer, substrate or structure to be produced divided by the displacement rate of the positioning table (7), and
- during the displacement of the positioning table, the model (6), the wafer, the substrate or structure are composed of a plurality of partial images by adequate addressing of the surface light modulator (13).

2. Illumination device according to claim 1, wherein
- the mirror device is defined by a semireflecting mirror (17) arranged at an angle of 45° to the optical axis determined by the lenses (15, 16).

3. Illumination device according to claim 1 or 2, wherein
- the filter device (18) is arranged in the focal plane of the schlieren lens (15), and
- the focussing device (4c) produces the point P, at which the light from the light source (2) is focussed, at such a distance from the mirror device (17) that the virtual point light source (P′), which can be associated with the point P by means of reflection at the mirror device (17), will be located in the focal plane of the schlieren lens (15).

4. Illumination device according to claim 1 or 2, wherein
- the focussing device (4c) produces the point P, at which the light from the light source (2) is focussed, at such a distance from the mirror device (17) that the virtual point light source (P′), which can be associated with the point P by means of reflection at the mirror device (17), will be produced with a first displacement relative to the focal plane of the schlieren lens (15) in the direction of the schlieren lens (15), and
- the filter device (18) is arranged with a second displacement relative to the focal plane of the schlieren lens (15) in the direction of the projection lens (16), said second displacement depending on said first displacement.

5. Illumination device according to one of the claims 1 to 4, wherein
- the focussing device (4c) and/or the mirror device (17) are arranged such that the light will fall at an oblique angle onto the surface of the surface light modulator (13) in such a way that undiffracted light will be reflected at an angle to the optical axis of the lenses (15, 16), and
- the filter device (18) permits a lateral spectrum of the light of the first order of diffraction and/or of higher orders of diffraction to pass to the projection lens (16), whereas it will filter out light of the zeroth-order of diffraction.

6. Illumination device according to one of the claims 1 to 5, wherein
- the pulsed laser light source is an excimer laser light source (2).

7. Illumination device according to one of the claims 1 to 6, wherein
- each surface area of the surface light modulator (13) has associated therewith two transistors each provided with one pair of control electrodes or with several pairs of control electrodes, which, in response to addressing of the respective surface area will each produce one or several diffraction grating(s) with the reflective surface and the viscoelastic control layer covered by said reflective surface.

8. Illumination device according to one of the claims 1 to 7, wherein
- an automatic loading and unloading device for wafers or substrates is provided, which permits fully automatic illumination of a batch of wafers or substrates.

9. Illumination device according to one of the claims 1 to 8, wherein
- a preadjustment means and a fine adjustment means are provided permitting accurate, repeated illuminations of the substrates during the production process.

10. Illumination device according to claim 9, wherein
- the surface light modulator (13) is used as a programmable reference mark during preadjustment and fine adjustment.

11. Illumination device according to one of the claims 1 to 10, wherein
- the reflective surface of the surface light modulator (13) is covered with a liquid-crystal layer, and
- the electrically addressable surface areas cause a phase displacement and, consequently, a diffraction of the incident light.

12. Illumination device according to one of the claims 1 to 11, wherein
- the surface light modulator (13) is provided with a reflective surface consisting of addressable mechanical elements, and wherein bending of said elements will cause a phase displacement and, consequently, a diffraction of the light.

13. Illumination device according to claim 12, wherein
- the mechanical elements are reeds which are adapted to be bent and which are provided with a reflecting surface.

## Revendications

1. Dispositif d'exposition lumineuse destiné à la réalisation de modèles pour la fabrication d'éléments électroniques, ou à l'exposition directe de plaques et substrats lors des étapes photolithographiques nécessaires à leur réalisation, ou de structures à couches photosensibles, avec une source de lumière (2) et un générateur de motifs (3), dans lequel
- le générateur de motifs (3) présente un système optique strioscopique (14) et un modulateur de lumière de surface (13) à adressage matriciel actif,
- le modulateur de lumière de surface (13) présente une surface réfléchissante dont les zones de surface adressées réfléchissent diffractée la lumière incidente et dont les zones de surface non-adressées réfléchissent non-diffractée la lumière incidente,
- le système strioscopique (14) présente un objectif strioscopique (15) du côté du modulateur de lumière de surface, un objectif de projection (16) du côté opposé au modulateur de lumière de surface (13) et un dispositif de miroir (17), disposé entre ces objectifs (15, 16), qui dirige la lumière de la source de lumière (2) vers la surface du modulateur de lumière de surface (13),
- l'objectif strioscopique (15) est disposé à une faible distance du modulateur de lumière de surface (13), par rapport à sa distance focale,
- est prévu un dispositif de focalisation (4c) destiné à concentrer la lumière de la source de lumière (2) à au moins un point P distant du dispositif de miroir (17), auquel peut être associée au moins une source de lumière ponctuelle virtuelle (P′) par réflexion du point P au dispositif de miroir (17),
- entre l'objectif strioscopique (15) et l'objectif de projection (16), dans le plan de l'image de diffraction, est disposé un dispositif de filtration (18) qui se présente de telle manière que
-- soit il filtre la lumière diffractée réfléchie par les zones de surface adressées du modulateur de lumière de surface (13) et laisse passer la lumière non-diffractée réfléchie par les zones de surface non-adressées, par l'objectif de projection (16), vers le modèle (6), la plaque, le substrat ou la structure,
-- soit il filtre la lumière non-diffractée réfléchie par les zones de surface non-adressées du modulateur de lumière de surface (13) et laisse passer la lumière diffractée réfléchie par les zones de surface adressées, par l'objectif de projection (16), vers le modèle (6), la plaque, le substrat ou la structure, et
- est prévu un plateau de positionnement (7) mobile, sur lequel peut être fixé le modèle (6), la plaque, le substrat ou la structure de telle manière que les zones de surface du modulateur de lumière de surface (13) peuvent être reproduites nettement sur le modèle (6), la plaque, le substrat ou la structure,
- la source de lumière est une source de lumière laser pulsée (2) qui se présente de telle manière que sa durée d'impulsion est plus courte que la dimension minimale du modèle, de la plaque, du substrat ou de la structure à produire divisée par la vitesse de déplacement du plateau de positionnement (7), et
- le modèle (6), la plaque, le substrat ou la structure est composé(e), pendant le déplacement du plateau de positionnement, d'une pluralité d'images partielles, par l'adressage correspondant du modulateur de lumière de surface (13).

2. Dispositif d'exposition lumineuse suivant la revendication 1, dans lequel le dispositif de miroir est constitué par un miroir (17) partiellement translucide disposé suivant un angle de 45° par rapport à l'axe optique déterminé par les objectifs (15, 16).

3. Dispositif d'exposition lumineuse suivant la revendication 1 ou 2, dans lequel
- le dispositif de filtration (18) est disposé dans le plan focal de l'objectif strioscopique (15), et
- le dispositif de focalisation (4c) génère le point P auquel est concentrée la lumière de la source de lumière (2) à une distance du dispositif de miroir (17) telle que la source de lumière ponctuelle virtuelle (P′) qui peut être associée au point P par réflexion au dispositif de miroir (17) se situe dans le plan focal de l'objectif strioscopique (15).

4. Dispositif d'exposition lumineuse suivant la revendication 1 ou 2, dans lequel
- le dispositif de focalisation (4c) génère le point P auquel est concentrée la lumière de la source de lumière (2) à une distance du dispositif de miroir (17) telle que la source de lumière ponctuelle virtuelle (P′) qui peut être associée au point P par réflexion au dispositif de miroir (17) est générée avec un premier décalage par rapport au plan focal de l'objectif strioscopique (15), en direction de l'objectif strioscopique (15), et
- le dispositif de filtration (18) est disposé avec un second décalage, fonction du premier décalage, par rapport au plan focal de l'objectif strioscopique (15), en direction de l'objectif de projection (16).

5. Dispositif d'exposition lumineuse suivant l'une des revendications 1 à 4, dans lequel
- le dispositif de focalisation (4c) et/ou le dispositif de miroir (17) sont disposés de telle manière que la lumière est incidente en oblique sur la surface du modulateur de lumière de surface de telle manière que la lumière non-diffractée est réfléchie suivant un angle par rapport à l'axe optique des objectifs (15,16), et
- le dispositif de filtration (18) laisse passer un spectre latéral de la lumière du premier ordre de diffraction et/ou d'ordres de diffraction supérieurs vers l'objectif de projection (16), mais filtre toutefois la lumière de l'ordre de diffraction zéro.

6. Dispositif d'exposition lumineuse suivant l'une des revendications 1 à 5, dans lequel la source de lumière laser pulsée est une source de lumière laser à excimer (2).

7. Dispositif d'exposition lumineuse suivant l'une des revendications 1 à 6, dans lequel à chaque zone de surfaces du modulateur de lumière de surface (13) sont associés deux transistors avec, chacun, une paire d'électrodes de commande ou plusieurs paires d'électrodes de commande qui, lors de l'adressage de la zone de surface concernée, génèrent, chacune, un ou plusieurs réseaux de diffraction avec la surface réfléchissante et la couche d'excitation viscoélastique qu'elle recouvre.

8. Dispositif d'exposition lumineuse suivant l'une des revendications 1 à 7, dans lequel est prévu un dispositif de chargement et déchargement automatique pour plaques ou substrats qui permet une exposition lumineuse entièrement automatique d'un lot de plaques ou substrats.

9. Dispositif d'exposition lumineuse suivant l'une des revendications 1 à 8, dans lequel sont prévus un dispositif de préréglage et un dispositif de réglage fin qui permettent l'exposition lumineuse répétée avec précision des substrats au cours du processus de fabrication.

10. Dispositif d'exposition lumineuse suivant la revendication 9, dans lequel le modulateur de lumière de surface (13) est utilisé comme repère programmable lors du préréglage et du réglage fin.

11. Dispositif d'exposition lumineuse suivant l'une des revendications 1 à 10, dans lequel
- la surface réfléchissante du modulateur de lumière de surface (13) est recouverte d'une couche de cristal liquide, et
- les zones de surface adressables électriquement provoquent un déphasage et, de ce fait, une diffraction de la lumière incidente.

12. Dispositif d'exposition lumineuse suivant l'une des revendications 1 à 11, dans lequel le modulateur de lumière de surface (13) présente une surface réfléchissante composée d'éléments mécaniques adressables dont la déformation provoque un déphasage et, de ce fait, une diffraction de la lumière incidente.

13. Dispositif d'exposition lumineuse suivant la revendication 12, dans lequel les éléments mécaniques se présentent sous forme de languettes déformables à surface réfléchissante.
